# EUROPEAN PATENT SPECIFICATION

(11) **EP 3 369 839 B1**
(45) Date of publication and mention of the grant of the patent: **07.10.2020**
(21) Application number: 16860078.1
(22) Date of filing: 18.08.2016
(51) Int. Cl.: C23C 4/00, C23C 4/06, C23C 4/08, C23C 4/12, C23C 4/123, C23C 4/14, C23C 14/56, B05B 9/00, B05B 13/02, B05B 15/25, C23C 14/26, B05B 1/04, B05B 7/16

(54) **PARTICLE GENERATING APPARATUS AND COATING SYSTEM INCLUDING SAME**
PARTIKELERZEUGUNGSVORRICHTUNG UND BESCHICHTUNGSSYSTEM DAMIT
APPAREIL DE GÉNÉRATION DE PARTICULES ET SYSTÈME DE REVÊTEMENT COMPRENANT CELUI-CI

(30) Priority: 29.10.2015 KR 20150151145
(43) Date of publication of application: 05.09.2018
(73) Proprietor: Posco, Pohang-si, Gyeongsangbuk-do 37859 (KR)
(72) Inventor: KIM, Jung-Kuk, Gwangyang-si Jeollanam-do 57807 (KR)
(74) Representative: Zech, Stefan Markus
(86) International application number: PCT/KR2016/009087
(87) International publication number: WO 2017/073894

(56) References cited:
- WO-A1-2007/045089
- JP-A- 2005 163 090
- KR-A- 20100 091 520
- KR-A- 20100 091 520
- KR-A- 20110 038 343
- KR-A- 20110 056 108
- KR-A- 20130 047 212
- US-A- 4 167 437
- US-A1- 2014 302 687

## Description

### [Technical Field]

The present disclosure relates to a particle generating apparatus and a coating system including the same, and more particularly, to a particle generating apparatus capable of generating uniform particles using a small amount of heat and a coating system including the same.

### [Background Art]

As a method of coating a continuously moving steel sheet, molten metal is converted into particle form under a vacuum atmosphere and is sprayed onto a continuously moving steel sheet, so particles, metal vapor, may be deposited on a steel sheet to coat the steel sheet.

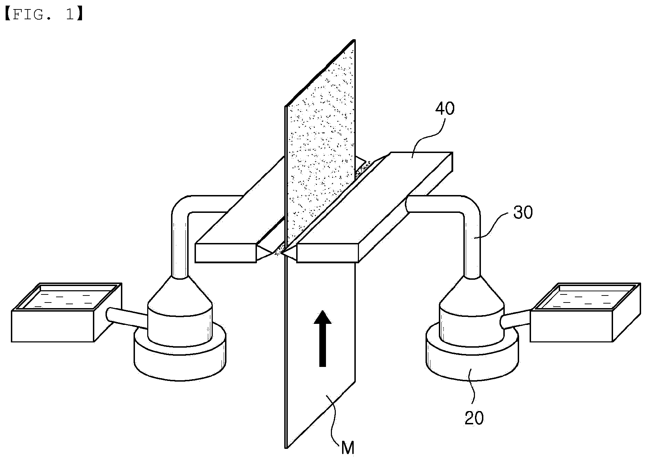

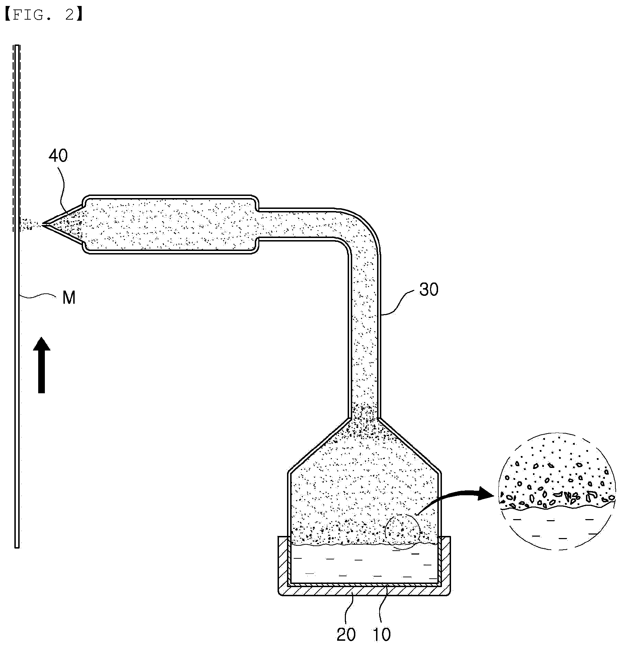

In FIGS. 1 and 2, a coating system according to the related art for coating a steel sheet in the method described above, is illustrated.

Referring to FIGS. 1 and 2, in a coating system according to the related art, a heating portion 20 is disposed to surround a container 10 in which a coating solution is stored, and the heating portion 20 heats the entirety of the container 10, and thus heats a coating solution stored in the container 10, and generates particles, metal vapor. The particles generated as described above are supplied to a spraying nozzle 40 through a particle supply pipe 30, and particles are sprayed from the spraying nozzle 40 and a steel sheet M is coated thereby.

As described above, in the case of a coating system according to the related art, the entirety of the container 10 is heated and particles, metal vapor, are generated. To heat the entirety of the container 10, an excessive amount of heat is supplied, and the entirety of molten metal is boiled at the same time, so abrupt turbulent fluid flow is formed on a surface of the molten metal. Thus, in addition to particles, as illustrated in an enlarged view of FIG. 2, there is a problem in which non-uniform particles are generated, thereby generating a coating defect.

Related to the general concept of evaporation, US 4 167 437 A discloses a boiling water evaporator for evaporation or distillation of sea water, for example. KR 2010 0091520 A discloses an evaporation cell for the evaporation of organic material.

### [Disclosure]

### [Technical Problem]

An aspect of the present disclosure may provide a particle generating apparatus capable of generating uniform particles using a small amount of heat by locally heating molten metal, and a coating system including the same.

### [Technical Solution]

According to an aspect of the present disclosure, a particle generating apparatus includes: a container in which a coating solution is stored; and a heating means immersed in the coating solution of the container that is configured to locally heat the coating solution so as to generate a particle to be deposited on an object to be coated.

The heating means includes: a heat-transfer pipe immersed in the coating solution; and an electric heating wire disposed in the heat-transfer pipe, and receiving electricity from an external source and generating heat.

The heat-transfer pipe may form a grid by connecting a plurality of pipes, and is immersed in an upper layer of the coating solution in parallel with a surface of the coating solution.

The particle generating apparatus may further include: a stirring means for stirring the coating solution by moving the heating means while the heating means is immersed in the coating solution.

The stirring means may include: a connecting member of which one side end is fastened to the heat-transfer pipe and of which the other side end protrudes externally of the container; a rotating member provided eccentrically with a protruding portion, and in which the other side end of the connecting member is inserted into the protruding portion; and a driving portion for rotating the rotating member.

The stirring means may be provided as a plurality of stirring means disposed in front of and behind the heat-transfer pipe, and rotates in response to an operation of the driving portion.

The stirring means may further include: a stirring member fastened to the heat-transfer pipe to protrude to a lower side surface of the heat-transfer pipe, immersed in the coating solution, and stirring the coating solution when the heat-transfer pipe moves.

The stirring member may be provided with an end portion in which a mixing bar is fastened to the stirring member perpendicularly.

The stirring member may be provided as a plurality of stirring members, and is fastened to the heat-transfer pipe to allow neighboring mixing bars to face in different directions.

The particle generating apparatus according to an example embodiment may further include: a coating solution supplying means connected to the container, and melting a supplied solid coating medium and supplying to the container.

The coating solution supplying means may include: a melting vessel disposed adjacent to the container, and having a communication hole connected to the container to allow a coating solution to flow to the container when the coating solution, having been melted, is above a certain liquid level; and a heating portion disposed to surround the melting vessel, and heating the solid coating medium, supplied to the melting vessel, to be melted.

The particle generating apparatus may further include: a raw particle supplying device connected to the melting vessel, and supplying a solid coating medium to the melting vessel.

The particle generating apparatus may further include: a liquid level sensor measuring a liquid level of a coating solution stored in the container; and a controlling portion receiving data from the liquid level sensor, and controlling the raw particle supplying device to selectively supply or interrupt a solid coating medium in response to a liquid level of a coating solution.

According to an aspect of the present disclosure, a coating system includes: the particle generating apparatus; a vacuum chamber surrounding all or a portion of the particle generating apparatus, and provided to allow an object to be coated to pass in a vacuum state; a spraying nozzle spraying particles to an object to be coated to coat the object to be coated; and a particle supply pipe connecting the particle generating apparatus to the spraying nozzle, that is configured to supply particles generated by the particle generating apparatus to the spraying nozzle.

To significantly reduce a change in flow cross sectional area of particles supplied to the spraying nozzle, the particle supply pipe is provided to have a width the same as a width of the spraying nozzle.

### [Advantageous Effects]

According to an exemplary embodiment in the present disclosure, a particle generating apparatus and a coating system including the same may have the effects of locally heating molten metal and generating uniform particles, and reducing an amount of heat consumption and saving energy.

According to an exemplary embodiment in the present disclosure, the effects of uniformly spraying particles, sprayed through a spraying nozzle, by significantly reducing a change in flow cross sectional area of supplied particles by providing a width of a particle supply pipe as the same as a width of a spraying nozzle, may be obtained.

### [Description of Drawings]

FIG. 1 is a schematic perspective view illustrating a coating system according to the related art.
FIG. 2 is a schematic cross-sectional view illustrating a coating system according to the related art.
FIG. 3 is a schematic perspective view illustrating a particle generating apparatus according to an example embodiment.
FIG. 4 is a schematic perspective view illustrating a heating means and a stirring means, extracted from a particle generating apparatus according to an example embodiment.
FIG. 5 is a schematic view illustrating an operating state of a particle generating apparatus according to an example embodiment.
FIG. 6 is a schematic view illustrating a configuration for supplying a coating solution, having been melted, from a particle generating apparatus according to an example embodiment.
FIG. 7 is a schematic perspective view illustrating a coating system according to an example embodiment.
FIG. 8 is a schematic perspective view illustrating a movement path of particles in a coating system according to an example embodiment.

### [Best Mode for Invention]

To facilitate understanding of the features of the present disclosure, a particle generating apparatus and a coating system including the same, related to an embodiment of the present disclosure, will be described in more detail.

To facilitate understanding of the embodiment described below, it should be noted that, in the accompanying drawings the same reference numerals denote the same elements, even when provided in different drawings. Moreover, in the following description of the present disclosure, a detailed description of known functions or configurations, related thereto, will be omitted in the case that the subject matter of the present disclosure would be rendered unclear thereby.

Hereinafter, a specific embodiment of the present disclosure will be described with reference to the accompanying drawings.

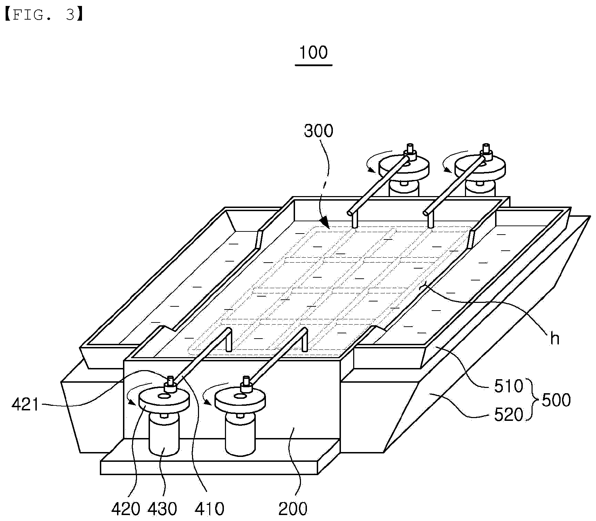

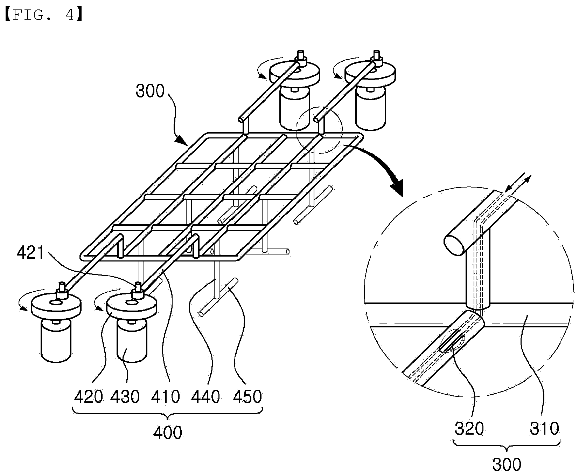

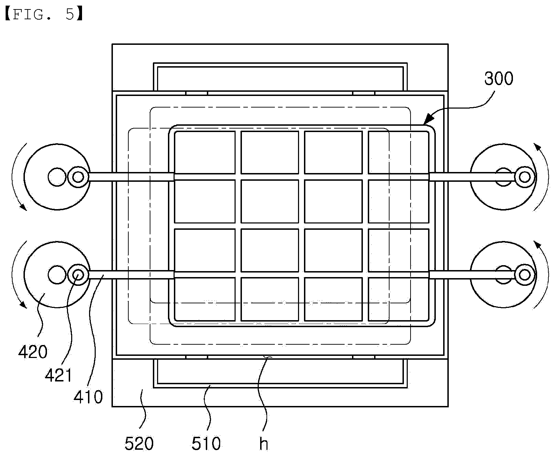

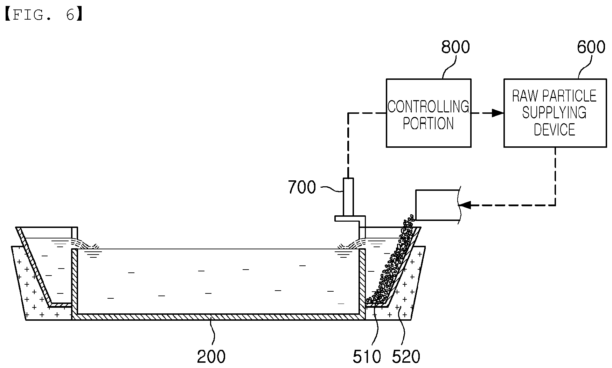

FIG. 3 is a schematic perspective view illustrating a particle generating apparatus according to an example embodiment, FIG. 4 is a schematic perspective view illustrating a heating means and a stirring means, extracted from the particle generating apparatus, and FIG. 5 is a schematic view illustrating an operating state of the particle generating apparatus. Moreover, FIG. 6 is a schematic view illustrating a configuration for supplying a coating solution, having been melted, from the particle generating apparatus.

Referring to FIGS. 3 to 6, a particle generating apparatus 100 according to an example embodiment may include a container 200 in which a coating solution is stored, and a heating means 300 immersed in the coating solution to locally heat the coating solution of the container 200 so as to generate a particle to be deposited on an object to be coated.

In other words, the heating means 300 is immersed in a coating solution stored in the container 200 and locally heats a surface, an upper layer of the coating solution, thereby generating particles, metal vapor, without directly heating the container 200.

The heating means 300, described above, may include a heat-transfer pipe 310 immersed in a coating solution, and an electric heating wire 320 disposed in the heat-transfer pipe 310, and receiving electricity from an external source and generating heat.

Moreover, the heat-transfer pipe 310 is provided to form a grid by connecting a plurality of pipes, and is preferably manufactured to be smaller than the container 200 so as to have a clearance to be moved in left and right directions while the heat-transfer pipe is immersed in a coating solution. The heat-transfer pipe 310 provided as described above is immersed in an upper layer of a coating solution in parallel with a surface of the coating solution and locally heats the coating solution.

The particle generating apparatus 100 according to an example embodiment further includes a stirring means 400 for stirring a coating solution by moving the heating means 300 while the heating means 300 is immersed in a coating solution. In other words, the stirring means 400 stirs a coating solution by moving the heating means 300 in all directions while the heating means 300 is immersed in the coating solution, thereby uniformly heating an upper layer of a coating solution.

To this end, the stirring means 400 includes a connecting member 410 of which one side end is fastened and fixed to the heat-transfer pipe 310, and of which the other side end protrudes externally of the container 200, a rotating member 420 provided eccentrically with a protruding portion 421, and in which the other side end of the connecting member 410 is inserted into the protruding portion 421, and a driving portion 430 rotating the rotating member 420.

In addition, the stirring means 400 is provided as a plurality of stirring means disposed in front of and behind the heat-transfer pipe 310, and is configured to rotate in response to an operation of the driving portion 430 and to stir a coating solution.

The stirring means 400 may further include a stirring member 440 fastened to the heat-transfer pipe 310 to protrude to a lower side surface of the heat-transfer pipe 310 and immersed in a coating solution, and for stirring a coating solution when the heat-transfer pipe 310 moves. In addition, the stirring member 440 is provided with a mixing bar 450 fastened to an end portion to be perpendicular to the stirring member 440. In other words, the stirring member 440 and the mixing bar 450 are provided in '┴' form to be fastened to the heat-transfer pipe 310.

Moreover, the stirring member 440 is provided as a plurality of stirring members, and may be fastened to the heat-transfer pipe 310 to allow neighboring mixing bars to face in different directions. In other words, as illustrated in FIG. 4, the stirring member 440 is fastened to the heat-transfer pipe 310 to allow the mixing bar 450 to be disposed in different directions. Thus, when the heat-transfer pipe 310 rotates, each mixing bar 450 is in friction with a coating solution in response to a direction in which the heat-transfer pipe 310 moves, thereby more effectively stirring the coating solution. In this case, a form of the stirring member 440 is not limited as described above, and may be provided as any device capable of stirring a coating solution, when the coating solution is heated.

Moreover, the particle generating apparatus 100 according to an example embodiment may further include a coating solution supplying means 500, a raw particle supplying device 600, a liquid level sensor 700, and a controlling portion 800.

The coating solution supplying means 500 is connected to the container 200, and allows a supplied solid coating medium to be melted and supplied to the container 200.

In more detail, the coating solution supplying means 500 may include a melting vessel 510 disposed adjacent to the container 200 and having a communication hole h connected to the container 200 to allow a coating solution to flow to the container 200, when the coating solution, having been melted, is above a certain liquid level, and a heating portion 520 disposed to surround the melting vessel 510 and heating a solid coating medium, supplied to the melting vessel 510, to be melted. Here, the heating portion 520 and the melting vessel 510 are disposed in both side surfaces of the container 200, and may serve to keep the container 200c warm above a certain temperature.

The raw particle supplying device 600 is connected to the melting vessel 510, and may supply a solid coating medium to the melting vessel 510.

The liquid level sensor 700 is disposed in the container 200, and measures a liquid level of a coating solution stored in the container 200. In addition, the controlling portion 800 receives data from the liquid level sensor 700, and controls the raw particle supplying device 600 to selectively supply or interrupt a solid coating medium in response to a liquid level of a coating solution. Here, the liquid level sensor 700 may be any known sensor, such as a contact-type sensor, measuring a liquid level of a coating solution using a buoyancy member, a noncontact-type sensor, measuring a liquid level of a coating solution using a laser, or the like.

In other words, a liquid level of a coating solution stored in the container 200 is measured by the liquid level sensor 700. When a liquid level of a coating solution, having been measured, is equal to or below a certain value, the controlling portion 800 allow the raw particle supplying device 600 to be operated so as to supply a solid coating medium to the melting vessel 510. In this case, by a solid coating medium supplied to the melting vessel 510, a liquid level of a coating solution, which has been melted in the melting vessel 510, is increased, so the coating solution flows to the container 200 through the communication hole h connecting the container 200 to the melting vessel 510. Thus, the container 200 is filled with the coating solution. Moreover, in a case in which the container 200 is filled with the coating solution and a liquid level of the coating solution reaches a certain height, the liquid level sensor 700 senses the case described above and transmits data to the controlling portion 800. Then, the controlling portion 800 allows the raw particle supplying device 600 to be stopped so as to no longer supply a coating solution to the container 200.

Due to such a configuration, a coating solution at a constant height can be automatically stored in the container 200.

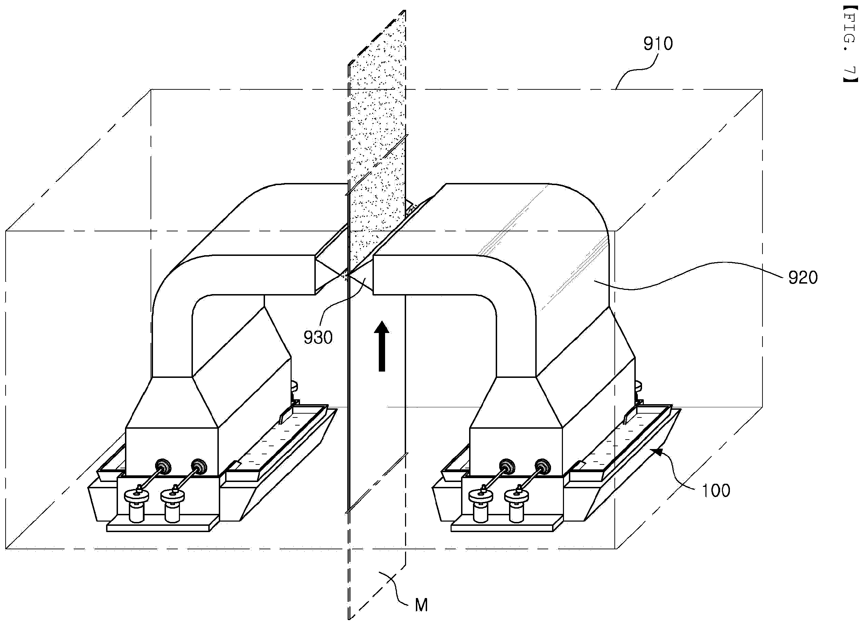

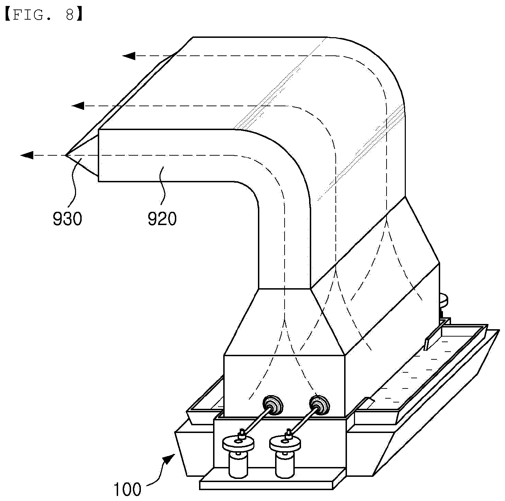

FIG. 7 is a schematic perspective view illustrating a coating system according to an example embodiment, and FIG. 8 is a schematic perspective view illustrating a movement path of particles in the coating system.

Referring to FIGS. 7 and 8, a coating system according to an example embodiment may include the particle generating apparatus 100 according to an example embodiment described above, a vacuum chamber 910 provided to surround the particle generating apparatus 100 and to allow an object M to be coated to pass in a vacuum state, a spraying nozzle 930 spraying particles to the object to be coated M to coat the object to be coated M, and a particle supply pipe 920 connecting the particle generating apparatus 100 to the spraying nozzle 930 and supplying particles generated by the particle generating apparatus 100 to the spraying nozzle 930.

In other words, the object to be coated M, continuously moving, passes through the vacuum chamber 910, particles, metal vapor, are sprayed through the spraying nozzle 930 to the object to be coated M in the vacuum chamber 910, and the particles are generated by the particle generating apparatus 100. The particles deposited on the object to be coated M may be zinc (Zn) vapor or zinc (Zn) -magnesium (Mg) vapor, which is an alloy element, or the like. Thus, the object to be coated M continuously passes through the vacuum chamber 910, and particles are deposited on the object to be coated M, so coating is continuously performed.

Moreover, to significantly reduce a change in flow cross-sectional area of particles supplied to the spraying nozzle 930, the particle supply pipe 920 may be provided to have a width the same as a width of the spraying nozzle 930.

In other words, in a case according to the related art, as illustrated in FIG. 1, a particle supply pipe is provided in a cylindrical shape, and is configured to supply particles to a spraying nozzle. Thus, particles are supplied through a particle supply pipe having a narrow flow cross-sectional area to a spraying nozzle in which a flow cross sectional area is instantaneously expanded. In this case, flow unevenness of particles occurs in a spraying nozzle, a problem in which a variation in a thickness of a coated film in a width direction is caused may occur.

Thus, to solve the problem described above, the particle supply pipe 920 is provided to have a width the same as a width of the spraying nozzle 930, and a change in flow cross sectional area of the particles supplied to the spraying nozzle 930 is removed, so particles sprayed through the spraying nozzle 930 may be uniformly sprayed in a width direction.

## Claims

1. A particle generating apparatus (100), comprising:
a container (200) in which a coating solution is stored; and
a heating means (300) immersed in the coating solution of the container (200) that is configured to locally heat the coating solution so as to generate a particle to be deposited on an object (M) to be coated,
wherein the heating means includes:
a heat-transfer pipe (310) immersed in the coating solution; and
an electric heating wire (320) disposed in the heat-transfer pipe (310), and receiving electricity from an external source and generating heat.

2. The particle generating apparatus (100) of claim 1, wherein the heat-transfer pipe (310) forms a grid by connecting a plurality of pipes, and is immersed in an upper layer of the coating solution in parallel with a surface of the coating solution.

3. The particle generating apparatus (100) of claim 1, further comprising:
a stirring means (400) for stirring the coating solution by moving the heating means (300) while the heating means (300) is immersed in the coating solution.

4. The particle generating apparatus (100) of claim 3, wherein the stirring means (400) includes:
a connecting member (410) of which one side end is fastened to the heat-transfer pipe (310) and of which the other side end protrudes externally of the container (100);
a rotating member (420) provided eccentrically with a protruding portion (421), and in which the other side end of the connecting member (410) is inserted into the protruding portion (421); and
a driving portion (430) for rotating the rotating member (420) .

5. The particle generating apparatus (100) of claim 4, wherein the stirring means (400) is provided as a plurality of stirring means disposed in front of and behind the heat-transfer pipe (310), and rotates in response to an operation of the driving portion (430).

6. The particle generating apparatus (100) of claim 3, wherein the stirring means (400) further includes:
a stirring member (440) fastened to the heat-transfer pipe (310) to protrude to a lower side surface of the heat-transfer pipe (310), immersed in the coating solution, and stirring the coating solution when the heat-transfer pipe (310) moves.

7. The particle generating apparatus (100) of claim 6, wherein the stirring member (440) is provided with an end portion in which a mixing bar (450) is fastened to the stirring member (440) perpendicularly.

8. The particle generating apparatus (100) of claim 7, wherein the stirring member (440) is provided as a plurality of stirring members, and is fastened to the heat-transfer pipe (310) to allow neighboring mixing bars to face in different directions.

9. The particle generating apparatus (100) of claim 1, further comprising:
a coating solution supplying means (500) connected to the container (200), and melting a supplied solid coating medium and supplying to the container (200).

10. The particle generating apparatus (100) of claim 9, wherein the coating solution supplying means (500) includes:
a melting vessel (510) disposed adjacent to the container (200), and having a communication hole (h) connected to the container (200) to allow a coating solution to flow to the container (200) when the coating solution, having been melted, is above a certain liquid level; and
a heating portion (520) disposed to surround the melting vessel (510), and heating the solid coating medium, supplied to the melting vessel (510), to be melted.

11. The particle generating apparatus (100) of claim 10, further comprising:
a raw particle supplying device (600) connected to the melting vessel (510), and supplying a solid coating medium to the melting vessel (510).

12. The particle generating apparatus (100) of claim 11, further comprising:
a liquid level sensor (700) measuring a liquid level of a coating solution stored in the container (200); and
a controlling portion (800) receiving data from the liquid level sensor (700), and controlling the raw particle supplying device (600) to selectively supply or interrupt a solid coating medium in response to a liquid level of a coating solution.

13. A coating system, comprising:
the particle generating apparatus (100) of any one of claims 1 to 12;
a vacuum chamber (910) surrounding all or a portion of the particle generating apparatus (100), and provided to allow an object (M) to be coated to pass in a vacuum state;
a spraying nozzle (930) spraying particles to an object (M) to be coated to coat the object (M) to be coated; and
a particle supply pipe (920) connecting the particle generating apparatus (100) to the spraying nozzle (930), that is configured to supply particles generated by the particle generating apparatus (100) to the spraying nozzle (930).

14. The coating system of claim 13, wherein, the particle supply pipe (920) is provided to have a width the same as a width of the spraying nozzle (930), such that the particle supply pipe (920) is configured to significantly reduce a change in flow cross sectional area of particles supplied to the spraying nozzle (930).

## Patentansprüche

1. Partikelerzeugungsvorrichtung (100), umfassend:
einen Behälter (200), in dem eine Beschichtungslösung aufbewahrt ist; und
eine in die Beschichtungslösung des Behälters (200) eingetauchte Erwärmungseinrichtung (300), die dazu ausgelegt ist, die Beschichtungslösung lokal zu erwärmen, um ein Partikel zu erzeugen, das auf einem zu beschichtenden Objekt (M) abgeschieden werden soll,
wobei die Erwärmungseinrichtung aufweist:
ein Wärmeübertragungsrohr (310), das in die Beschichtungslösung eingetaucht ist; und
einen elektrischen Heizdraht (320), der in dem Wärmeübertragungsrohr (310) angeordnet ist, Elektrizität von einer externen Quelle erhält und Wärme erzeugt.

2. Partikelerzeugungsvorrichtung (100) nach Anspruch 1, wobei das Wärmeübertragungsrohr (310) ein Gitter bildet, indem es mehrere Rohre verbindet und in einer oberen Schicht der Beschichtungslösung parallel zu einer Oberfläche der Beschichtungslösung eingetaucht ist.

3. Partikelerzeugungsvorrichtung (100) nach Anspruch 1, darüber hinaus umfassend:
eine Rühreinrichtung (400), um die Beschichtungslösung zu rühren, indem die Erwärmungseinrichtung (300) bewegt wird, während die Erwärmungseinrichtung (300) in die Beschichtungslösung eingetaucht ist.

4. Partikelerzeugungsvorrichtung (100) nach Anspruch 3, wobei die Rühreinrichtung (400) aufweist:
ein Verbindungselement (410), von dem ein Seitenende am Wärmeübertragungsrohr (310) befestigt ist, und von dem das andere Seitenende außerhalb des Behälters (200) vorsteht;
ein exzentrisch vorgesehenes Drehelement (420) mit einem vorstehenden Abschnitt (421), und bei dem das andere Seitenende des Verbindungselements (410) in den vorstehenden Abschnitt (421) eingesetzt ist; und
einen Antriebsabschnitt (430), um das Drehelement (420) zu drehen.

5. Partikelerzeugungsvorrichtung (100) nach Anspruch 4, wobei die Rühreinrichtung (400) als eine Vielzahl von Rühreinrichtungen vorgesehen ist, die vor und hinter dem Wärmeübertragungsrohr (310) angeordnet sind, und sich im Ansprechen auf einen Betrieb des Antriebsabschnitts (430) dreht.

6. Partikelerzeugungsvorrichtung (100) nach Anspruch 3, wobei die Rühreinrichtung (400) darüber hinaus aufweist:
ein Rührelement (440), das am Wärmeübertragungsrohr (310) zu einer unteren Seitenfläche des Wärmeübertragungsrohrs (310) vorstehend befestigt ist, in die Beschichtungslösung eingetaucht ist und die Beschichtungslösung rührt, wenn sich das Wärmeübertragungsrohr (310) bewegt.

7. Partikelerzeugungsvorrichtung (100) nach Anspruch 6, wobei das Rührelement (440) mit einem Endabschnitt versehen ist, in dem ein Mischstab (450) senkrecht am Rührelement (440) befestigt ist.

8. Partikelerzeugungsvorrichtung (100) nach Anspruch 7, wobei das Rührelement (440) als eine Vielzahl von Rührelementen vorgesehen ist, und am Wärmeübertragungsrohr (310) so befestigt ist, dass es benachbarte Rührstäbe in verschiedene Richtungen gerichtet sein lässt.

9. Partikelerzeugungsvorrichtung (100) nach Anspruch 1, darüber hinaus umfassend:
eine Beschichtungslösungszufuhreinrichtung (500), die an den Behälter (200) angeschlossen ist und ein zugeführtes, festes Beschichtungsmittel schmilzt und dem Behälter (200) zuführt.

10. Partikelerzeugungsvorrichtung (100) nach Anspruch 9, wobei die Beschichtungslösungszufuhreinrichtung (500) aufweist:
ein Schmelzgefäß (510), das angrenzend an den Behälter (200) angeordnet ist und eine Verbindungsöffnung (h) hat, die an den Behälter (200) angeschlossen ist, um eine Beschichtungslösung zum Behälter (200) fließen zu lassen, wenn sich die Beschichtungslösung, nachdem sie geschmolzen wurde, über einem bestimmten Füllstand befindet; und
einen Erwärmungsabschnitt (520), der das Schmelzgefäß (510) umgebend angeordnet ist und das zu schmelzende, feste Beschichtungsmittel erwärmt, das dem Schmelzgefäß (510) zugeführt wird.

11. Partikelerzeugungsvorrichtung (100) nach Anspruch 10, darüber hinaus umfassend:
eine Rohpartikelzufuhrvorrichtung (600), die an das Schmelzgefäß (510) angeschlossen ist und dem Schmelzgefäß (510) ein festes Beschichtungsmittel zuführt.

12. Partikelerzeugungsvorrichtung (100) nach Anspruch 11, darüber hinaus umfassend:
einen Füllstandsensor (700), der einen Füllstand der in dem Behälter (200) aufbewahrten Beschichtungslösung misst; und
einen Steuerabschnitt (800), der Daten vom Füllstandsensor (700) empfängt und die Rohpartikelzufuhrvorrichtung (600) steuert, um eine festes Beschichtungsmittel im Ansprechen auf einen Füllstand der Beschichtungslösung selektiv zuzuführen oder zu unterbrechen.

13. Beschichtungssystem, umfassend:
die Partikelerzeugungsvorrichtung (100) nach einem der Ansprüche 1 bis 12;
eine Vakuumkammer (910), welche die gesamte oder einen Teil der Partikelerzeugungsvorrichtung (100) umgibt und vorgesehen ist, um ein zu beschichtendes Objekt (M) in einem Vakuumzustand durchlaufen zu lassen;
eine Sprühdüse (930), die Partikel auf ein zu beschichtendes Objekt (M) sprüht, um das zu beschichtende Objekt (M) zu beschichten; und
ein Partikelzufuhrrohr (920), das die Partikelerzeugungsvorrichtung (100) an die Sprühdüse (930) anschließt und dazu ausgelegt ist, durch die Partikelerzeugungsvorrichtung (100) erzeugte Partikel der Sprühdüse (930) zuzuführen.

14. Beschichtungssystem nach Anspruch 13, wobei das Partikelzufuhrrohr (920) mit einer Breite versehen ist, bei der es sich um dieselbe wie eine Breite der Sprühdüse (930) handelt, so dass das Partikelzufuhrrohr (920) dazu ausgelegt ist, eine Änderung in einer Durchflussquerschnittsfläche von der Sprühdüse (930) zugeführten Partikeln signifikant zu reduzieren.

## Revendications

1. Appareil de génération de particules (100), comprenant :
un récipient (200) dans lequel une solution de revêtement est stockée ; et
un moyen de chauffage (300) immergé dans la solution de revêtement du récipient (200), configuré pour chauffer localement la solution de revêtement de manière à générer une particule à déposer sur un objet (M) à revêtir,
sachant que le moyen de chauffage inclut :
un tuyau calorifique (310) immergé dans la solution de revêtement ; et
un fil électrique chauffant (320) disposé dans le tuyau calorifique (310), et recevant de l'électricité depuis une source externe et générant de la chaleur.

2. L'appareil de génération de particules (100) de la revendication 1, sachant que le tuyau calorifique (310) forme une grille en connectant une pluralité de tuyaux, et est immergé dans une couche supérieure de la solution de revêtement parallèlement à une surface de la solution de revêtement.

3. L'appareil de génération de particules (100) de la revendication 1, comprenant en outre :
un moyen d'agitation (400) destiné à agiter la solution de revêtement en déplaçant le moyen de chauffage (300) tandis que le moyen de chauffage (300) est immergé dans la solution de revêtement.

4. L'appareil de génération de particules (100) de la revendication 3, sachant que le moyen d'agitation (400) inclut :
un élément de connexion (410) dont une extrémité latérale est fixée au tuyau calorifique (310) et dont l'autre extrémité latérale dépasse à l'extérieur du récipient (200) ;
un élément rotatif (420) disposé de manière excentrique avec une partie saillante (421), et dans lequel l'autre extrémité latérale de l'élément de connexion (410) est insérée dans la partie saillante (421) ; et
une partie entraînement (430) destinée à faire tourner l'élément rotatif (420).

5. L'appareil de génération de particules (100) de la revendication 4, sachant que le moyen d'agitation (400) est prévu comme pluralité de moyens d'agitation disposés devant et derrière le tuyau calorifique (310), et tourne en réponse à un fonctionnement de la partie entraînement (430).

6. L'appareil de génération de particules (100) de la revendication 3, sachant que le moyen d'agitation (400) inclut en outre :
un élément d'agitation (440) fixé au tuyau calorifique (310) pour dépasser vers une surface latérale inférieure du tuyau calorifique (310), immergé dans la solution de revêtement, et agitant la solution de revêtement lorsque le tuyau calorifique (310) se déplace.

7. L'appareil de génération de particules (100) de la revendication 6, sachant que l'élément d'agitation (440) est pourvu d'une partie extrémité dans laquelle une barre de mélange (450) est fixée perpendiculairement à l'élément d'agitation (440).

8. L'appareil de génération de particules (100) de la revendication 7, sachant que l'élément d'agitation (440) est prévu comme pluralité d'éléments d'agitation, et fixé au tuyau calorifique (310) pour permettre à des barres de mélange contiguës d'être tournées dans différentes directions.

9. L'appareil de génération de particules (100) de la revendication 1, comprenant en outre :
un moyen de fourniture de solution de revêtement (500) connecté au récipient (200), et faisant fondre un fluide de revêtement solide fourni et le fournissant au récipient (200).

10. L'appareil de génération de particules (100) de la revendication 9, sachant que le moyen de fourniture de solution de revêtement (500) inclut :
une cuve de fusion (510) disposée de manière adjacente au récipient (200), et présentant un trou de communication (h) connecté au récipient (200) pour permettre à une solution de revêtement de s'écouler vers le récipient (200) lorsque la solution de revêtement, une fois fondue, se trouve au-dessus d'un certain niveau de liquide ; et
une partie chauffante (520) disposée pour entourer la cuve de fusion (510), et chauffant le fluide de revêtement solide, fourni à la cuve de fusion (510), à faire fondre.

11. L'appareil de génération de particules (100) de la revendication 10, comprenant en outre :
un dispositif de fourniture de particules brutes (600) connecté à la cuve de fusion (510), et fournissant un fluide de revêtement solide à la cuve de fusion (510).

12. L'appareil de génération de particules (100) de la revendication 11, comprenant en outre :
un capteur de niveau de liquide (700) mesurant un niveau de liquide d'une solution de revêtement stockée dans le récipient (200) ; et
une partie commande (800) recevant des données depuis le capteur de niveau de liquide (700), et commandant le dispositif de fourniture de particules brutes (600) pour fournir ou interrompre sélectivement un fluide de revêtement solide en réponse à un niveau de liquide d'une solution de revêtement.

13. Système de revêtement, comprenant :
l'appareil de génération de particules (100) de l'une quelconque des revendications 1 à 12 ;
une chambre à vide (910) entourant tout ou partie de l'appareil de génération de particules (100), et prévu pour permettre à un objet (M) à revêtir de passer dans un état de vide ;
une tuyère de pulvérisation (930) pulvérisant des particules sur un objet (M) à revêtir pour revêtir l'objet (M) à revêtir ; et
un tuyau de fourniture de particules (920) connectant l'appareil de génération de particules (100) à la tuyère de pulvérisation (930), configuré pour fournir des particules générées par l'appareil de génération de particules (100) à la tuyère de pulvérisation (930).

14. Le système de revêtement de la revendication 13, sachant que le tuyau de fourniture de particules (920) est prévu pour avoir une largeur identique à une largeur de la tuyère de pulvérisation (930), de sorte que le tuyau de fourniture de particules (920) soit configuré pour réduire significativement un changement d'aire de section transversale d'écoulement de particules fournies à la tuyère de pulvérisation (930).
